# EUROPEAN PATENT APPLICATION

(11) **EP 4 765 644 A1**
(43) Date of publication of application: **24.06.2026**
(21) Application number: 24222442.6
(22) Date of filing: 20.12.2024
(51) Int. Cl.: H03K 19/003, H02M 3/07

(54) **CIRCUITS AND METHODS FOR ACTIVE POWER SUPPLY DECOUPLING IN SYNCHRONOUS DIGITAL LOGIC**

(71) Applicant: EM Microelectronic-Marin SA, 2074 Marin (CH)
(72) Inventor: NERAD, Jiri, 15800 Praha (CZ); LUKES, Zdenek, 39143 Mlada Vozice (CZ)
(74) Representative: ICB SA

(57) **Abstract**

This invention discloses circuits and methods for active power supply decoupling in synchronous digital systems. An active decoupling unit, incorporating switched capacitors, addresses voltage dips caused by simultaneous switching events. During peak demand, the unit quickly discharges capacitors to stabilize the supply voltage, while recharging occurs during low-demand intervals. This approach significantly reduces the required capacitor size and enhances charge delivery efficiency. Additionally, complementary clock signals can synchronize decoupling units, allowing partial or full compensation during both rising and falling edges of the clock. The invention provides enhanced area efficiency and reliability in synchronous digital logic environments.

## Description

### Field of the invention

The invention pertains to the field of digital integrated circuit design, particularly to power management techniques in synchronous digital logic systems. It focuses on methods and apparatus for mitigating local supply voltage fluctuations induced by the simultaneous switching activity of large groups of digital gates, such as flip-flops, during production testing or normal operation.

### Background of the invention

In synchronous digital logic systems, maintaining a stable supply voltage is critical for ensuring reliable operation and preventing timing violations. One common challenge arises during operations involving many flip-flops clocked simultaneously, such as during digital scan testing. This synchronous switching activity creates a short but significant peak in supply current demand, which can cause local supply voltage dips exceeding the specifications of standard cell libraries. Such voltage dips often result in signal integrity issues, timing violations, or even operational errors, making scan chain insertion techniques unreliable.

The prevailing approach to address this issue involves the use of passive decoupling capacitors. These capacitors are typically implemented as filler cells distributed across the integrated circuit layout. Their role is to locally store charge and supply it during peak current demand. However, the effectiveness of passive capacitors is inherently limited. The amount of charge they can deliver is proportional to the permissible voltage drop, as dictated by the relationship *dQ = C*(*V*) · *dV.* In scenarios where only minimal voltage drops are tolerable, achieving adequate decoupling requires extremely large capacitance, consuming significant chip area. Furthermore, only a small fraction of the total charge stored in these capacitors is utilized to mitigate transient current peaks, leading to inefficient use of silicon resources.

Despite these measures, passive decoupling is insufficient in scenarios demanding near-zero voltage fluctuations. The growing complexity and density of modern digital systems exacerbate this issue, highlighting the need for more efficient and scalable solutions to supply voltage regulation.

The present invention aims to address these limitations by providing a novel approach that significantly enhances the efficiency of decoupling mechanisms in synchronous digital systems, particularly during transient high-current events.

### Summary of the invention

One aspect of the present invention relates to a pump unit. A pump unit may be understood as an electronic device configured to control and optimize the transfer of energy within a system. Such a unit typically interfaces with multiple components, such as energy storage units, switching elements, and control circuitry, to regulate energy flow in response to external signals.

It may be provided that the pump unit comprises a positive voltage potential input, a negative voltage potential input, and a clock signal input. A positive voltage potential input may be understood as an interface that supplies a higher voltage level to the pump unit, while a negative voltage potential input serves as a lower or reference voltage level, commonly referred to as ground. A clock signal input may be understood as an interface for receiving a periodic signal that synchronizes operations within the pump unit. One advantage of these inputs is that they enable the pump unit to operate as part of a synchronized digital system, ensuring that energy transfer and storage processes occur in a coordinated manner, reducing the risk of timing errors and improving overall system reliability.

It may also be provided that the pump unit comprises a control circuit and a charge transfer circuit, the charge transfer circuit being driven by the control circuit. A control circuit may be understood as an arrangement of components designed to generate signals that manage the behaviour of other circuits. A charge transfer circuit may be understood as a subsystem that facilitates the movement of electrical energy between storage units and other parts of the system. One advantage of this arrangement is that the control circuit enables precise regulation of the charge transfer circuit, ensuring that energy is stored and released in a controlled manner. This controlled behaviour helps optimize the energy distribution pattern, reducing the supply voltage ripple and enhancing the reliability of the overall system.

It may further be provided that the charge transfer circuit comprises a first energy storage unit, a second energy storage unit, and a discharge switch connected between the first and second energy storage units. An energy storage unit may be understood as a component, such as a capacitor, that temporarily stores electrical energy for later use. An essential property of such energy storage unit is the ability to temporarily supply electric current or electric charge into the power distribution network in order to provide electric power that is consumed by other parts of the system. A discharge switch may be understood as an element capable of opening or closing a circuit to control the flow of energy between connected components. One advantage of including these components is that the energy storage units can store energy during idle periods and release it when required, while the discharge switch enables selective transfer of energy, enhancing the flexibility and adaptability of the circuit to varying system demands.

It may also be provided that when the clock signal input is at a low level, the discharge switch is open and the first and second energy storage units are charging. A low-level clock signal may be understood as a phase of the clock signal where its voltage is at or near its minimum value. The open state of the discharge switch prevents energy flow between the storage units, ensuring that each unit can independently accumulate charge from the voltage potential inputs. One advantage of this configuration is that it maximizes the energy stored in the units during inactive periods, ensuring sufficient energy availability for subsequent operations.

Finally, it may be provided that when the clock signal input is at a high level, the discharge switch is closed and the first and second energy storage units are discharging. A high-level clock signal may be understood as a phase of the clock signal where its voltage is at or near its maximum value. The closed state of the discharge switch enables energy flow between the storage units and into the system, ensuring efficient delivery of stored energy to its intended destination. One advantage of this configuration is that it enables the efficient delivery of energy during peak consumption times, improving the overall responsiveness and performance of the system.

By coordinating the interactions between the control circuit, the charge transfer circuit, the energy storage units, and the discharge switch, the pump unit achieves enhanced energy management capabilities, offering significant improvements in supply voltage ripple and therefore operational reliability.

It may be provided that, when the clock signal input is at a low level, the first and second energy storage units are charging as a parallel combination. A parallel combination may be understood as a configuration where the terminals of the first and second energy storage units are connected to the same voltage potential inputs, ensuring that both units independently accumulate charge simultaneously. One advantage of this configuration is that it allows both storage units to charge concurrently, thereby maximizing the energy stored within a single clock cycle. This ensures that the available stored energy is sufficient to handle subsequent discharge operations, even under varying load conditions.

It may further be provided that, when the clock signal input is at a high level, the first and second energy storage units are discharging as a series combination. A series combination may be understood as a configuration where the energy storage units are connected end to end, allowing their voltages to add up while discharging through the same circuit. One advantage of this configuration is that it significantly increases the total output current delivered during the discharge phase, enhancing the power available to downstream components. This higher voltage is particularly beneficial for driving circuits with stringent voltage requirements, ensuring stable and reliable operation.

By coordinating the parallel and series configurations of the energy storage units with the clock signal, the pump unit achieves a dynamic and flexible energy management system. This configuration enhances energy efficiency by fully utilizing the storage units during both charging and discharging phases. A person skilled in the art would appreciate that such an arrangement improves system performance by ensuring both high energy storage capacity and high energy delivery efficiency, addressing challenges in modern electronic systems.

It may be provided that the pump unit comprises a first energy storage unit implemented as a PMOS capacitor and a second energy storage unit implemented as an NMOS capacitor. A PMOS capacitor may be understood as a capacitive element constructed using PMOS transistors, where the combination of the conductive gate plate, the gate insulation dielectric and the conductive p-type channel region provides specific electrical characteristics optimized for energy storage and transfer. An NMOS capacitor may be understood as a capacitive element constructed using NMOS transistors, where the combination of the conductive gate plate, the gate insulation dielectric and the conductive n-type channel region is employed to provide electrical characteristics complementary to the behaviour of the PMOS capacitor.

One advantage of this configuration is the complementary nature of the PMOS and NMOS capacitors, which allows for efficient utilization of the positive and negative voltage potential inputs. The PMOS capacitor, being optimized for the positive voltage potential input, and the NMOS capacitor, optimized for the negative voltage potential input, enable a balanced energy storage and release process.

This combination also allows the pump unit to achieve greater stability and faster charge-discharge cycles, ensuring a robust response to varying energy demands within the system. A person skilled in the art would recognize that this arrangement enhances the overall performance of the pump unit by leveraging the unique advantages of both PMOS and NMOS technologies in a complementary manner.

It may be provided that the first and second energy storage units are implemented as low leakage capacitor types, decoupling elements, or filler cell structures. A low leakage capacitor type may be understood as a capacitor designed to minimize charge loss over time, ensuring efficient energy storage with reduced energy dissipation. A decoupling element may be understood as a component used to stabilize voltage levels by supplying instantaneous current demands and mitigating voltage fluctuations. A filler cell structure may be understood as a physical or functional placeholder within an integrated circuit, designed to maintain layout continuity while potentially serving as an energy storage element.

One advantage of using low leakage capacitor types is the improved retention of stored energy, which is particularly beneficial for circuits requiring prolonged periods between charge and discharge cycles. This reduces energy wastage and enhances the overall efficiency of the pump unit. Decoupling elements contribute to system stability by effectively addressing transient voltage dips and supplying current where needed, ensuring reliable operation under dynamic conditions. Filler cell structures, when utilized as energy storage units, optimize the use of available silicon area in integrated circuits, providing additional energy storage capacity without significantly impacting design constraints.

By offering flexibility in the implementation of the energy storage units, the pump unit can be tailored to meet specific design requirements, including energy efficiency, layout optimization, and system stability. A person skilled in the art would recognize that this versatility enables the pump unit to adapt to a wide range of applications while maintaining robust and efficient energy management capabilities.

It may be provided that the pump unit comprises a control circuit and a charge transfer circuit, wherein the control circuit includes a two-stage CMOS inverter. A CMOS inverter may be understood as a circuit composed of complementary metal-oxide-semiconductor or field-effect transistors designed to invert the input signal. A two-stage configuration may be understood as a cascading arrangement of two such inverters, where the first stage inverts the clock signal input and the second stage inverts the output of the first stage, producing a non-inverted version of the clock signal. One advantage of this arrangement is the generation of complementary control signals, which ensures precise and synchronized operation of the charge and discharge switches. This synchronization enables efficient energy transfer and minimizes timing errors, thereby enhancing the overall reliability of the pump unit.

It may be provided that the first energy storage unit is connected to the positive voltage potential input and is driven by a first charge switch connected to the negative voltage potential input, the first charge switch being controlled by the output of the first stage. A charge switch may be understood as a transistor configured to selectively connect the energy storage unit to its respective voltage input, allowing it to charge. The control of the first charge switch by the first stage of the CMOS inverter ensures that the first energy storage unit charges only during the appropriate clock phase, preventing unnecessary energy dissipation. One advantage of this configuration is the precise control of the charging process, optimizing energy storage efficiency and reducing power loss.

It may further be provided that the second energy storage unit is connected to the negative voltage potential input and is driven by a second charge switch connected to the positive voltage potential input, the second charge switch being controlled by the output of the second stage. This complementary configuration, wherein the second storage unit is driven by a complementary control signal but also comprises a charge switch of complementary type with respect to the first storage unit, ensures that the two energy storage units operate synchronously.

Specifically, in the first storage unit, a NMOS transistor may be used as a charge switch requiring a high control signal level to activate whereas, in the second storage unit, a PMOS transistor may be used as a charge switch, requiring a low control signal level to activate. As the first storage unit is driven by the output of the front inverter stage producing an inverted version of the clock signal while the second storage unit is driven by the output of the second inverter stage producing a non-inverted version of the clock signal, the charge switches are both active and both inactive at the same time.

It may also be provided that the discharge switch is connected between the first and second energy storage units and is driven by the outputs of both the first and second stages. Driving the discharge switch with the outputs of both CMOS inverter stages ensures synchronized operation with the clock signal. One advantage of this arrangement is the rapid and efficient transfer of stored energy to the load during the discharge phase. By leveraging the synchronized control signals, this configuration minimizes delay and enhances the responsiveness of the pump unit.

This combination of a two-stage CMOS inverter, complementary charge switches, and a discharge switch ensures precise energy management and seamless integration with the system clock signal. The described configuration enables efficient charging and discharging cycles, reduces power losses, and improves the stability and reliability of the pump unit in high-performance digital systems. A person skilled in the art would recognize that these features collectively enhance the ability of the pump unit to address transient current demands while maintaining robust and efficient operation.

It may be provided that the first energy storage unit is of approximately the same size or capacitance as the second energy storage unit, and the drive or channel conductance of the discharge switch is larger than the drive or channel conductance of the first and second charge switches. An energy storage unit may be understood as a device, such as a capacitor, that temporarily stores electrical energy. Having the first and second energy storage units of approximately the same size or capacitance ensures similar time constants during the charging phase, and particularly, balanced voltage distribution at the end of the discharging phase where voltages across both units are approximately equal to half the supply voltage. One advantage of such operation is maintaining small variations of the voltage dependent capacitances of both charge units by avoiding those operating points where the voltage across the energy storage unit is near zero. This is of particular importance if the energy storage units are implemented as MOS capacitor structures.

A discharge switch may be understood as a transistor or a combination of transistors configured to connect the energy storage units in a series configuration during the discharge phase. Drive or channel conductance may be understood as the measure of the ability of a switch to conduct current when activated, determined by the physical properties of the transistor, such as channel width and length. Designing the discharge switch with a larger drive or channel conductance than that of the charge switches ensures a significantly faster discharge process. One advantage of this arrangement is the rapid energy transfer during the discharge phase, which reduces response times and improves the dynamic performance of the pump unit. By maintaining a slower recharge process, controlled by the lower conductance of the charge switches, this configuration also minimizes power consumption at times between the edges of the system clock.

This balance between the energy storage unit sizes and the conductance characteristics of the switches enables the pump unit to deliver precise and efficient energy management, ensuring stability and reliability in high-performance digital circuits. A person skilled in the art would appreciate that this configuration reduces the amount of supply voltage ripple and therefore enhances the overall robustness of the power distribution network.

The pump unit may include a control signal and a logic gate integrated into the clock input to electively disable the clock signal. A control signal may be understood as an external or internal signal used to enable or disable specific functionalities of a circuit. A logic gate may be understood as a digital circuit element that performs a logical operation, such as AND, OR, or NOT, on its input signals to produce an output. In this configuration, the logic gate is used to conditionally pass or block the clock signal based on the state of the control signal.

The pump unit may further include a first clamp switch and a second clamp switch.

According to a second aspect of the invention, there is provided a system comprising supply rails, one or more flip-flops or a scan chain structure, and a pump unit according to the first object of the invention. Supply rails may be understood as electrical conductors that distribute voltage potentials, typically providing a positive voltage potential and a negative or reference voltage potential throughout the system. Flip-flops may be understood as digital circuit elements used for storing binary information, operating synchronously with a clock signal to manage state transitions in the system. A scan chain structure may be understood as a configuration used in digital circuits, particularly in design-for-testability (DFT) methodologies, to enable efficient testing and debugging of integrated circuits. It is commonly implemented in sequential circuits, such as flip-flops, to simplify the process of verifying functionality and detecting manufacturing defects.

One advantage of this configuration is that the pump unit actively compensates for transient supply current peaks caused by the switching activity of the flip-flops. By stabilizing the voltage levels across the supply rails, the pump unit reduces timing errors and ensures reliable operation of the flip-flops. Another advantage is the improved area efficiency of the system, as the pump unit minimizes the need for excessive decoupling capacitance along the supply rails. Additionally, the integration of the pump unit enhances the scalability of the system, enabling it to support larger numbers of flip-flops without compromising stability or performance.

By creating a standard block incorporating the pump unit with one or more flip-flops, the system level design becomes more predictable thanks to the possibility of optimising the transient supply current profile of such block at transistor level using advanced methods of post layout extraction and analogue simulation. A person skilled in the art would recognize that this configuration addresses critical challenges in modern digital systems, including power integrity and transient response management.

The system might comprise a parallel combination of two pump units according to the first aspect of the invention, or one or more of its im provements.

One advantage of configuring the system with a parallel combination of two pump units is the increased capacity for energy management. By combining the output of two pump units, the system can handle higher current demands, making it suitable for applications requiring substantial power delivery. Another advantage is the redundancy introduced by the parallel arrangement. If one pump unit encounters a fault, the second unit can continue operating, ensuring system reliability, and minimizing the risk of operational downtime.

It may be provided that the two pump units are controlled by complementary clock signals. A complementary clock signal may be understood as a pair of periodic signals that are out of phase with one another, such that when one signal is at a high level, the other is at a low level, and vice versa. This arrangement ensures that the two pump units operate in alternating phases, with one unit charging while the other is discharging. The energy storage units in the two pump units may be of identical capacitor sizing or of different capacitor sizing.

One advantage of this configuration is the continuous and balanced management of energy transfer. By alternately activating the pump units, the system can maintain a steady flow of energy, reducing fluctuations in supply current. A person skilled in the art would recognize that this configuration ensures smoother energy delivery, reduces stress on individual components, and optimizes the overall performance and reliability of the system.

It may be provided that the two pump units controlled by complementary clock signals comprise energy storage units of different capacitor sizing. Capacitor sizing may be understood as the design specification of a capacitor, typically defined by its capacitance value, which determines the amount of electric charge it can store at a given voltage. Using capacitors with different sizing allows for asymmetrical energy storage and release characteristics, enabling tailored energy management based on the specific requirements of the system.

One advantage of performing complementary operation of two pump units with different capacitor sizing is the ability to create an asymmetrical compensation pattern. This configuration is particularly useful in applications where the supply current peaks or charge steps differ between the rising and falling edges of the clock signal. By adjusting the relative capacitances, the complementary combination of pump units can provide more precise compensation for these asymmetrical current demands, improving the stability and reliability of the power network. A person skilled in the art would recognize that this flexibility makes the pump unit adaptable to a wider range of operating conditions, enhancing its effectiveness in managing transient currents in high-performance digital systems.

It may be provided that the two pump units are controlled by the same clock polarity with a delay between the two pump units. A delay between the two pump units may be understood as a temporal offset introduced between the operating phases of the two units, allowing one to begin its discharge phase later than the other. The energy storage units in the two pump units may be of identical capacitor sizing or of different capacitor sizing.

One advantage of the parallel use of two pump units, with identical or complementary clock polarity, is the precise match between the transient current demands of the flip flops and the transient current profile supplied by the active compensation, leading to very effective reduction of instantaneous current peaks on the power network. By introducing a delay between the pump units, the system can maintain a steadier energy flow, minimizing voltage ripple and improving overall stability. Another advantage is the optimization of energy resources, as this approach allows current compensation to be tailored to the dynamic needs of the system. A person skilled in the art would recognize that this arrangement significantly enhances the robustness, efficiency, and reliability of the system in environments with high energy demands.

According to a third aspect of the invention, it is provided a method for transferring energy in a digital system, the method comprising the step of providing a pump unit according to the first aspect of the invention.

The method may comprise a step of optimizing the compensation of supply current peaks in the digital system by adjusting the energy storage size in at least one of the pump units.

The method may comprise a step of achieving full or partial compensation of supply currents peaks in the digital system.

The method may comprise a step of minimizing the supply current ripple measured by an analogue equipment by adjusting the energy storage size in at least one of the pump units.

The method may comprise a step of minimizing the supply current ripple measured by the analogue equipment by passing the clock signal via a variable delay circuit.

### Brief description of the drawings

The present invention will be described subsequently in more detail with reference to the attached drawing, given by way of examples, but in no way limited thereto, in which:
- Figure 1 illustrates a system according to one embodiment,
- Figure 2 depicts structural component of a pump unit according to one embodiment,
- Figure 3 shows an embodiment of the pump unit of Figure 2,
- Figure 4 presents simulated waveforms of the pump unit of Figure 3 during operation,
- Figure 5 illustrates a complementary pump unit configuration of Figure 3,
- Figure 6 displays the instantaneous current waveforms,
- Figure 7 shows the integrated current waveforms,
- Figure 8 illustrates multiple pump units operating in parallel,
- Figure 9 shows an embodiment of the pump unit of Figure 2.

### Detailed description of the invention

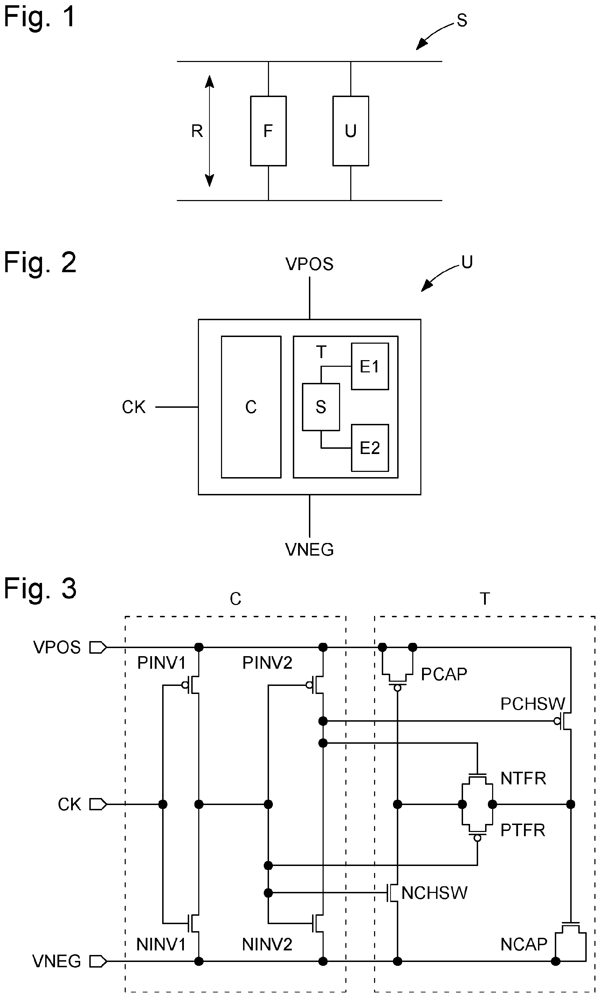

Figure 1 is an example of a system S according to one embodiment.

System S comprises supply rails R, a flip-flop F and a pump unit U according to one embodiment.

A method for transferring energy in a digital system comprising the step of providing a pump unit is also described.

As illustrated in Figure 2, the pump unit U comprises:
- a positive voltage potential input VPOS, a negative voltage potential input VNEG, a clock signal input CK,
- a control circuit C, and
- a charge transfer circuit T, the charge transfer circuit being driven by the control circuit and comprising a first energy storage unit E1, a second energy storage unit E2 and a discharge switch S connected between the first and second energy storage units.

The control circuit C and the charge transfer circuit T are configured such that:
- when the clock signal input is at a low level, the discharge switch is open and the first and second energy units are charging, and
- when the clock signal input is at a high level, the discharge switch is closed and the first and second energy units are discharging.

Figure 3 illustrates an embodiment of the pump unit P.

The control circuit C comprises a two-stage CMOS inverter with a first stage connected to the clock signal input and a second stage connected to the output of the first stage.

The first stage inverter is formed with a NMOS transistor NINV1 and a PMOS transistor PINV1 and the second stage with a NMOS transistor NINV2 and a PMOS transistor PINV2.

The first storage unit PCAP is implemented as a PMOS capacitor. The first storage unit is connected to the positive voltage potential input VPOS and driven by a first charge switch NCHSW implemented as a NMOS transistor and connected to the negative voltage potential input VNEG. The first charge switch is controlled by an output of the first stage of the inverter.

The second storage unit NCAP is implemented as a NMOS capacitor. The second storage unit is connected to the negative voltage potential input VNEG and driven by a second charge switch PCHSW implemented as a PMOS transistor connected to the positive voltage potential input VPOS. The second charge switch is controlled by the output of the second stage of the inverter.

The discharge switch is implemented as a NMOS switch NTFR and a PMOS switch PTFR driven by the outputs of the first and second stages.

When the external clock signal is at a low level, the charge switches NCHSW and PCHSW are in a conductive state, with the first charge switch configured to close when its gate terminal is at a high level and the second charge switch configured to close when its gate terminal is at a low level. Simultaneously, the floating discharge switch is in a nonconductive state, wherein its parallel components NTFR and PTFR are configured to remain open when their respective gate terminals are at a low level and a high level.

Conversely, when the external clock signal is at a high level, the charge switches NCHSW and PCHSW are in a nonconductive state, with the first charge switch configured to open when its gate terminal is at a low level and the second charge switch configured to open when its gate terminal is at a high level. During this phase, the floating discharge switch is in a conductive state, wherein its parallel components NTFR and PTFR are configured to close when their respective gate terminals are at a high level and a low level.

Therefore, the following charge transfer operations are implemented:
- When the clock signal is at a low level, the NMOS capacitor and the PMOS capacitor are connected across the supply rails R and are charged to the full static supply voltage.
- As the clock signal transitions from a low level to a high level (rising edge), the NMOS and PMOS capacitors are reconfigured into a series connection across the supply rails. This series configuration facilitates a transient charge transfer from the capacitors to the power network. If the capacitance of the NMOS capacitor is approximately equal to that of the PMOS capacitor, both capacitors discharge to approximately half their full voltage, resulting in each capacitor retaining half of its initial charge. This configuration represents the preferred mode of operation.
- While the clock signal remains at a high level, the NMOS and PMOS capacitors remain connected in the series configuration described above, continuing to interact with the power network.
- As the clock signal transitions from a high level to a low level (falling edge), the transfer gate comprising the transistors NTFR and PTFR is fully deactivated, isolating the series connection of the capacitors. At this point, the charge switches are activated, initiating the recharge process.
- When the clock signal is again at a low level, the recharge process continues until the NMOS and PMOS capacitors are fully charged to the supply voltage or until the next clock cycle begins.

The transistors forming the discharge transfer gate are designed for low ohmic resistance when in a conductive state, achieved through a large channel width and a small channel length. This design ensures that the discharge process occurs rapidly, optimizing the efficiency of energy transfer.

The recharge switches, NCHSW and PCHSW, are configured for significantly higher ohmic resistance when in a conductive state. This is achieved by designing these switches with a relatively small channel width and a relatively large channel length, contrasting with the transistors in the discharge transfer gate. As a result, the recharge process is inherently much slower than the discharge process. The difference in current magnitude and duration between these two processes can span several orders of magnitude, particularly when a low clock frequency is employed, allowing for precise control and efficient energy management within the system.

In contrast to passive supply decoupling, which uses capacitors permanently connected across the supply rails, this invention employs a method of active decoupling that dynamically uses switched capacitor units. These units actively transfer stored charge to compensate for transient supply current peaks, significantly enhancing power delivery stability. These units actively transfer a significantly greater portion of the total charge stored in the capacitors to locally supply the peak current demand during brief peak periods, enabling rapid discharge of the switched capacitors. The method further involves slow recharging of the capacitors during the relatively long intervals between clock edges, when there is minimal digital activity among the large group of flip-flops designed to operate synchronously. The current required for this slow recharge, spread over an extended duration, is proportionally much smaller than the peak current at the clock edge, with the difference spanning several orders of magnitude. This approach ensures a minimal and well-regulated voltage drop across the supply lines.

Figure 2 illustrates the operational behaviour of a pump unit as described in the invention. The figure presents a simulated time-domain representation of key signals, demonstrating the dynamic operation of the charge transfer process during different phases of the clock cycle.

The top trace T1 in the figure represents the external clock signal, a periodic waveform alternating between low and high levels. This signal governs the timing of the operation of the pump unit, including the charging and discharging phases of the energy storage units.

The second trace T2 in the figure shows the voltage at the gate terminal of the NMOS capacitor. During the low phase of the clock signal, this voltage ensures the NMOS capacitor is connected to the supply rails and enters the charging phase. As the clock transitions to a high level, the gate voltage changes to facilitate the series connection and discharge phase.

The third trace T3 displays the gate voltage of the PMOS capacitor. Like the NMOS capacitor, the gate voltage transitions in synchronization with the clock signal to manage the charging and discharging processes.

It is noteworthy that, despite the relatively low supply voltage (approximately 1V) and the use of a floating transfer gate to facilitate the discharge of the capacitor devices, the transient discharge process occurs at an exceptionally rapid rate. Both capacitors reach the target voltage level of half the supply voltage within nanoseconds, as indicated by the horizontal scale of the diagram.

A flip-flop circuit typically includes two latch type subcircuits driven by two complementary clock signals. Due to complementary operation, the full flip-flop generates two supply current peaks: one at the rising edge and one at the falling edge of the external clock. The two current peaks are not equal but both can be significant, in particular if a large number of flip-flop circuits is used. In contrast, the pump unit presented is only active in one half period of the clock signal, recharging when the clock signal is low and injecting charge into the power network when the clock signal subsequently makes a rising edge.

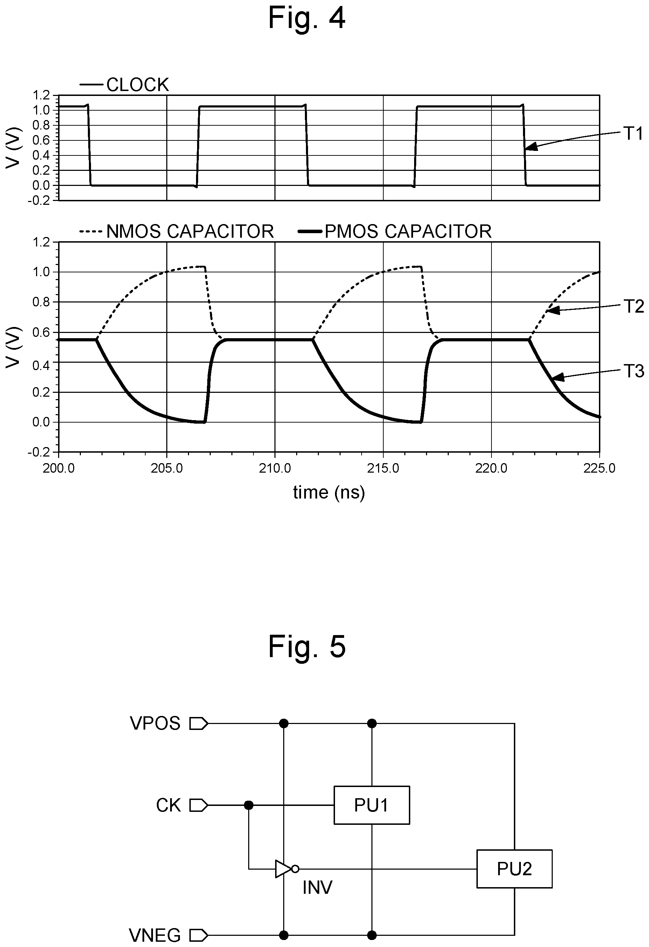

In order to compensate both supply current peaks generated by the groups of flip-flop cells in the course of the full clock period, two pump units PU1 and PU2, controlled by complementary clock signals can be used as illustrated in Figure 5.

The first pump unit PU1 is controlled by the primary clock signal, while the second pump unit PU2 is controlled by its inverted counterpart.

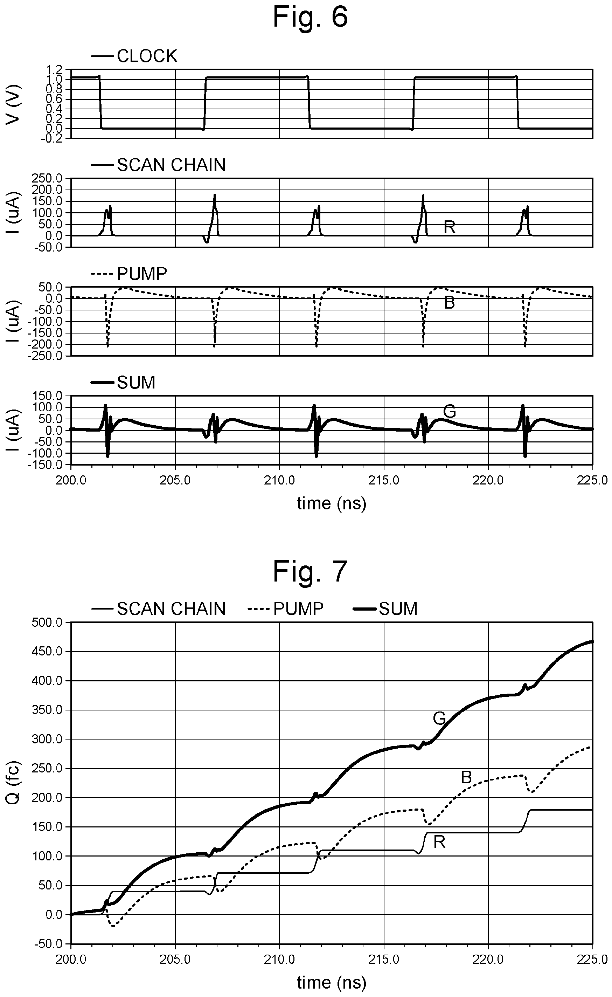

Figures 6 and 7 illustrate the simulated performance of a system incorporating two pump units in a complementary configuration, designed to stabilize supply current for a group of ten scan chain type flip-flops. The simulations were conducted using a 40 nm CMOS process with post-layout netlists, providing realistic insights into the system operation under highspeed conditions.

Figure 6 depicts the instantaneous current waveforms associated with the flip-flop bank, the complementary pump units, and their combined effect:
- Flip-Flop Bank Current R: Shows the current consumption of the flip-flops during clock transitions, with distinct peaks at rising and falling edges.
- Pump Unit Current B: Illustrates the alternating operation of the complementary pump units. Positive segments represent the recharge phases, while negative segments indicate discharge phases.
- Combined Current G: Represents the net current supplied to the combination of flip-flop bank and pump units, demonstrating the stabilizing effect of the pump units in reducing supply current fluctuations.

Figure 7 presents the indefinite integrals of the instantaneous current waveforms, corresponding to the cumulative charge transferred over time:
- Flip-Flop Bank Charge R: Shows discrete charge steps associated with the current peaks of the flip-flop transitions.
- Pump Unit Charge B: Displays the charge transfer behaviour of the pump units, with gradual recharge and sharp discharge phases.
- Combined Charge G: Demonstrates continuous charge flow to the combination of flip-flops and pump units, confirming the overall stability of the system.

As it may be observed:
- The pump units effectively complement the supply current demands of the flip-flops, as shown by the alternating discharge and recharge phases of the pump units in trace B.
- The combined current waveform (trace G) highlights the reduction of supply current peaks, ensuring more stable power delivery to the full system.
- The integrated charge waveforms illustrate smooth and uninterrupted charge transfer to the system, underscoring the effectiveness of this method in mitigating transient current spikes and maintaining consistent energy availability.

The method may comprise a step of minimizing a digital error rate of the system by adjusting the sizes of the energy storage units.

It may be provided that the method comprises a step of achieving full or partial compensation of supply current peaks in the digital system.

In the case of full compensation, the pump unit is designed to entirely offset the supply current peaks generated by the flip-flop or flip-flop bank. This is achieved by carefully selecting the sizes of the pump capacitors and optimizing their operation using post-layout simulations. Full compensation ensures that the current supplied by the pump unit matches the current demand of the digital logic, resulting in minimal voltage fluctuations across the supply rails. This approach is particularly advantageous for high-performance systems where precise power management is critical.

Alternatively, partial compensation is implemented to address a portion of the supply current peaks. This involves designing the pump unit to provide a controlled amount of charge transfer that reduces the overall impact of current spikes without fully neutralizing them. Partial compensation is particularly useful in scenarios where a balance between system performance and resource utilization is required. It minimizes the silicon area needed for pump unit implementation while still delivering significant improvements in power stability and error rate reduction.

In the case shown in Figures 6 and 7, the pump units are configured for full compensation, where the capacitor sizes are optimized to entirely cover the discrete charge steps generated by the flip-flop bank. However, the applications of this invention are not necessarily limited to achieving such a level of compensation.

Partial compensation, which addresses only a portion of the discrete charge steps generated by the flip-flop bank, is anticipated to result in significant improvements in error rate and may even enable error-free operation. Implementing partial compensation requires less silicon area, which can enhance design efficiency and potentially increase the robustness of the overall system.

As shown in Figure 6, the total charge transferred over the given time period, and consequently the average current consumed by the entire circuit including the pump unit combination, is approximately twice that of the flip-flop bank alone. This increase is primarily attributed to energy losses in the switching devices used for charging and discharging the pump capacitors.

In production testing scenarios, the test equipment can readily supply sufficient power at virtually no additional cost, while improvements in test time or reliability result in substantial cost savings.

As can be seen from Figure 6, focusing on individual supply current pulses at times of clock edges, the transient current profile or shape of the flip-flop bank (R) is wider and has longer duration than the transient current profile or shape of the pump combination (B) which is narrower, has shorter duration and a sharper peak. Consequently, due to imperfect cancellation, their sum (G) tends to oscillate at times of clock edges.

While this is not expected to be critical, further improvement is possible.

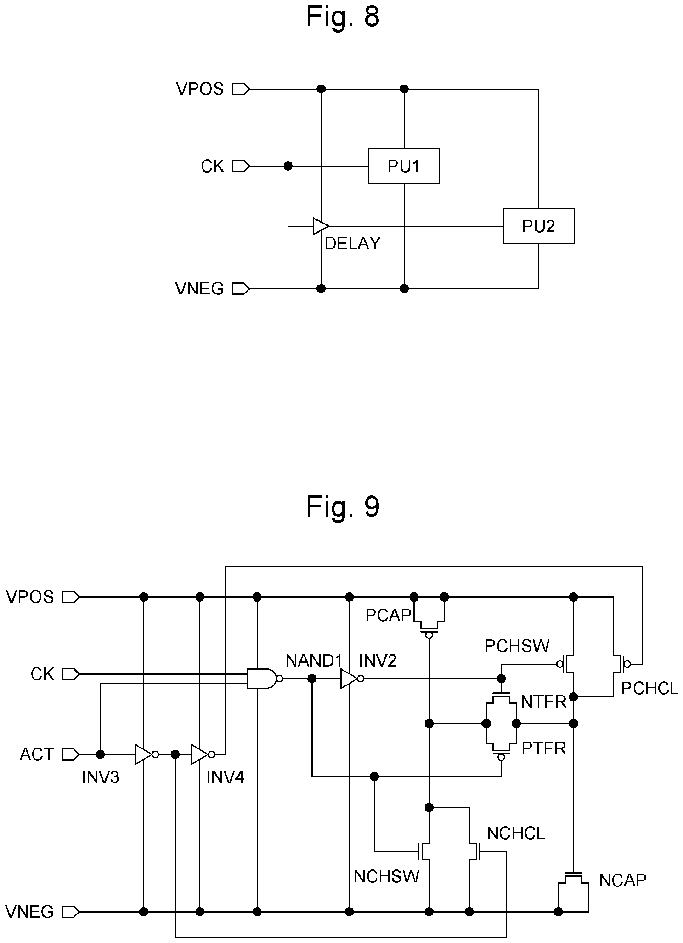

Figure 8 illustrates how multiple pump units can be added in parallel, using the same clock polarity with a small clock delay between the individual units obtained by inserting a delay element or standard cell.

The areas or sizes of tank capacitors (NCAP and PCAP in Figure 3) in individual pump units can be identical or different and can also be tailored to specific operational requirements. In this way, multiple pump pulses with independent control of individual peak magnitudes and small delays in between can be combined, forming a resulting pulse with greater width and controllable shape that can be adjusted to match the supply current profile of the flip-flop bank.

The method may comprise a step of minimizing the instantaneous supply current variation or fluctuation measured by the analogue equipment by passing the clock signal via a variable delay circuit and adjusting the delay of that circuit. Such variation or fluctuation of supply current can cause supply voltage ripple or ringing that can affect digital components.

The compensation technique presented in this invention ensures error-free digital operation thanks to reduced supply voltage ripple or ringing within the power distribution network. This reduction enables the use of higher clock frequencies. In the context of production testing, this feature can enhance the primary metric of commercial interest, namely the reduction of test time.

This compensation method also provides excellent risk control, as the pump unit or active decoupling circuit can be easily switched to passive decoupling by halting the clock signal. This functionality is straightforward to implement by incorporating a logic gate at the clock input of the pump unit. This approach allows for selective activation or deactivation of individual units or sections of the design, which is particularly advantageous when the decoupling circuits are integrated into flip-flop banks as described earlier.

Post-silicon tuning, if required, is straightforward and involves adjusting the number of active pump units or modifying the clock delay using a variable delay circuit. This flexibility allows the complementary pump units to be fine-tuned independently to address asymmetric supply current peaks, accommodating differences in current demand or charge steps between the rising and falling edges of the clock signal.

The proposed pump circuit design is fully compliant with ESD standards, as no gate oxide capacitance is directly connected to both supply rails, ensuring robust protection against electrostatic discharge.

Additionally, the proposed topology is well-suited for semiconductor technologies where gate oxide leakage is significant, and MOS capacitor devices are not viable for implementing the relatively large capacitors required (NCAP and PCAP in Figure 3). In such cases, low-leakage capacitors, decoupling elements, or filler cell structures can be utilized to replace NCAP and PCAP while maintaining equivalent functionality.

As illustrated in Figure 9, the pump unit may include a control signal ACT and a logic gate NAND1 integrated into the clock input to electively disable the clock signal processed by the pump unit. When the signal ACT is at high level, the pump unit shown in Figure 9 is functionally equivalent to the pump unit shown in Figure 2 as the logic gate NAND1 in Figure 9 outputs an inverted version of the input clock signal CK in the same way as the combination of transistors NINV1, PINV1 in Figure 2 and the general inverter stage INV2 is functionally equivalent to the combination of transistors NINV2, PINV2 in Figure 2. When the signal ACT is at low level, the logic gate NAND1 outputs a constant high level, the inverter INV2 outputs a constant low level, the behaviour of the pump unit is equivalent to stopping the clock CK at low level and the pump unit remains in the charge state, acting as a passive decoupling unit.

To further improve the performance in the passive decoupling mode, the pump unit may include optional clamp switches NCHCL and PCHCL and optional control inverters INV3, INV4. The clamp switches NCHCL and PCHCL are placed in parallel with the charge switches NCHSW and PCHSW, respectively. However, the clamp switches are designed to have much larger drive or channel conductance than the charge switches. In terms of physical dimensions, the clamp switches typically have large width and small length whereas the charge switches typically have small width and large length. When the control signal ACT is at high level, the pump unit is in the active decoupling mode and the control inverters INV3, INV4 generate control voltages for the clamp switches in such a way that the gate of the NMOS switch NCHCL is at low level and the gate of the PMOS switch PCHCL is at high level. Consequently, both clamp switches are open and have no effect on the operation of the pump unit. When the control signal ACT is at low level, the pump unit is in the passive decoupling mode, and the control inverters INV3, INV4 generate control voltages for the clamp switches in such a way that the gate of the NMOS switch NCHCL is at high level and the gate of the PMOS switch PCHCL is at low level. Consequently, both clamp switches are closed and provide low ohmic connections between both MOS capacitor units and supply rails, and therefore, the performance of the pump unit in the passive mode is comparable to the performance of the dedicated decoupling cell.

The addition of a control signal and a logic gate to the clock input as well as the optional addition of control inverters and clamp switches enables the pump unit to transition seamlessly between active and passive decoupling modes, providing operational flexibility. Active decoupling may be understood as an operation where switched capacitors are dynamically charged and discharged in synchronization with the clock signal to stabilize the power supply. Passive decoupling, in contrast, refers to a static operation where the capacitors remain permanently connected between the supply rails, providing charge directly without active switching.

One advantage of this configuration is the ability to selectively enable or disable the active decoupling functionality of the pump unit. This is particularly useful in scenarios where active compensation is not required, such as during idle periods or in sections of the circuit with low current demand. Transitioning to passive decoupling in these cases reduces unnecessary power consumption associated with clock-driven switching operations, enhancing overall energy efficiency.

Another advantage is the flexibility provided by this design. By stopping the clock signal and converting to passive decoupling, the pump unit can continue to provide basic voltage stabilization through its capacitors without requiring active control. This ensures continued operation of the power network even if the active components of the pump unit are disabled, adding robustness to the system.

This approach also simplifies power management in complex systems. By selectively activating or deactivating the pump unit based on the control signal, different sections of the circuit can be independently optimized for energy efficiency and performance. A person skilled in the art would recognize that this capability improves the scalability and adaptability of the system, enabling it to meet diverse operational requirements while maintaining stable and reliable power distribution.

It may be provided that the method includes minimizing supply current ripple measured by analogue equipment by adjusting the size of the first and second energy storage units. By increasing or optimizing energy storage sizes, current variations are absorbed, reducing ripple and stabilizing the power supply.

## Claims

1. A pump unit (U) comprising:
- a positive voltage potential input (VPOS), a negative voltage potential input (VNEG), a clock signal input (CK),
- a control circuit (C), and
- a charge transfer circuit (T), the charge transfer circuit being driven by the control circuit and comprising a first energy storage unit (E1), a second energy storage unit (E2) and a discharge switch (S) connected between the first and second energy storage units,
wherein:
- when the clock signal input is at a low level, the discharge switch is open and the first and second energy units are charging, and
- when the clock signal input is at a high level, the discharge switch is closed and the first and second energy units are discharging.

2. The pump unit according to claim 1, wherein:
- when the clock signal input is at a low level, the first and second energy units are charging as a parallel combination, and
- when the clock signal input is at a high level, the first and second energy units are discharging as a series combination.

3. The pump unit according to claim 1 or 2, wherein the first energy storage unit is implemented as a PMOS capacitor, and the second energy storage unit is implemented as a NMOS capacitor.

4. The pump unit according to claim 1 or 2, wherein the first and second energy storage units are implemented as low leakage capacitor types or decoupling elements or filler cell structures.

5. The pump unit according to any preceding claims, wherein:
- the control circuit (C) comprises a two-stage CMOS inverter with a first stage connected to the clock signal input and a second stage connected to an output of the first stage,
- the first storage unit (E1) is connected to the positive voltage potential input (VPOS) and driven by a first charge switch (NCHSW) connected to the negative voltage potential input (VNEG), the first charge switch being controlled by an output of the first stage,
- the second storage unit (E2) is connected to the negative voltage potential input and driven by a second charge switch (PCHSW) connected to the positive voltage potential input, the second charge switch being controlled by the output of the second stage,
- the discharge switch (S) connected between the first and second energy storage units, the discharge switch being driven by the output of the first and second stages.

6. The pump unit according to any preceding claims, wherein first energy storage unit (E1) is of approximately the same size or capacitance as the second energy storage unit, and the drive or channel conductance of the discharge switch (S) is larger than the drive or channel conductance of the first charge switch of the first energy storage unit and the second charge switch of the second energy storage unit.

7. The pump unit according to any preceding claims, further including a control signal and a logic gate integrated into the clock input to electively disable the clock signal.

8. The pump unit according to claim 7, further including a first clamp switch (NCHCL) and a second clamp switch (PCHCL).

9. A system (S) comprising supply rails (R), one or more flipflops (F) or a scan chain structure and a pump unit according to claim 1.

10. The system according to claim 9, comprising a parallel combination of two pump units according to claim 1 to 8.

11. The system according to claim 9 or 10, wherein the two pump units are controlled by complementary clock signals and wherein the energy storage units in the two pump units are of identical capacitor sizing or of different capacitor sizing.

12. The system according to claim any claim 9 to 11, wherein the two pump units are controlled by a same clock polarity with a delay in between the two pump units and wherein the energy storage units in the two pump units are of identical capacitor sizing or of different capacitor sizing.

13. A method for transferring energy in a digital system, the method comprising the step of providing a pump unit according to any claims 1 to 12.

14. The method according to the preceding claim, comprising a step of optimizing the compensation of supply current peaks in the digital system by adjusting the energy storage size in at least one of the pump units.

15. The method according to any one of claims 13 to 14, comprising a step of achieving full or partial compensation of supply currents peaks in the digital system.

16. The method according to any claims 13 to 15, comprising a step of minimizing the supply current ripple measured by an analogue equipment by adjusting the energy storage size in at least one of the pump units.

17. The method according to any claims 13 to 16, comprising a step of minimizing the supply current ripple measured by the analogue equipment by passing the clock signal via a variable delay circuit.
